# FASCICULE DE BREVET EUROPEEN

(11) **EP 2 342 745 B1**
(45) Date de publication et mention de la délivrance du brevet: **11.02.2015**
(21) Numéro de dépôt: 09760239.5
(22) Date de dépôt: 29.10.2009
(51) Int. Cl.: H01L 21/762, H01L 21/84

(54) **PROCEDE D'ELABORATION D'UN SUBSTRAT HYBRIDE AYANT UNE COUCHE CONTINUE ELECTRIQUEMENT ISOLANTE ENTERREE**
VERFAHREN ZUR HERSTELLUNG EINES HYBRIDSUBSTRATS MIT EINER EINGEBETTETEN ELEKTRISCH ISOLIERENDEN DURCHGEHENDEN SCHICHT
METHOD FOR PRODUCING A HYBRID SUBSTRATE WITH AN EMBEDDED ELECTRICALLY INSULATING CONTINUOUS LAYER

(30) Priorité: 31.10.2008 FR 0806072
(43) Date de publication de la demande: 13.07.2011
(73) Titulaire: Commissariat à l'Énergie Atomique et aux Énergies Alternatives, 75015 Paris (FR)
(72) Inventeur: SIGNAMARCHEIX, Thomas, F-38660 La Terrasse (FR); FOURNEL, Franck, F-38190 Villard-Bonnot (FR); CLAVELIER, Laurent, F-38000 Grenoble (FR); DEGUET, Chrystel, F-38330 Saint Ismier (FR)
(74) Mandataire: Colombo, Michel
(86) Numéro de dépôt international: PCT/FR2009/052091
(87) Numéro de publication internationale: WO 2010/049654

(56) Documents cités:
- WO-A1-03/083930
- WO-A2-2008/114107
- US-A- 5 310 446
- US-A1- 2004 241 958
- US-A1- 2005 116 290
- US-A1- 2007 013 001
- US-B1- 7 060 585

## Description

L'invention concerne un procédé de formation d'un substrat hybride, c'est-à-dire une structure micro-technologique comportant une couche mixte formée de familles de zones différentes, en ce qui concerne leurs matériaux constitutifs ou au moins en ce qui concerne leurs orientations cristallines. Un tel substrat est parfois aussi appelé « substrat mixte », en raison de la mixité des zones au sein d'une même couche. Plus précisément, l'invention concerne l'élaboration d'un substrat hybride comportant une couche continue électriquement isolante longée par la couche mixte.

Il est à noter que l'épaisseur d'une couche mixte est typiquement comprise entre 1 nm et 1µm.

Dans le domaine de la micro-technologie, lorsqu'il s'agit de produire des composants électroniques, des composants optiques ou optoélectroniques, voire des composants micro-mécaniques (des micro-accélérateurs, par exemple), on utilise souvent des substrats en silicium, mais il faut bien comprendre que d'autres matériaux sont également utilisables, souvent d'autres matériaux semi-conducteurs, formés d'éléments de la colonne IV du tableau périodique des éléments (germanium, notamment, ainsi que ses alliages avec du silicium), voire des colonnes III-V (notamment GaAs ou InP), ou même II-VI de ce tableau, voire LiNbO₃, SiC, le diamant, etc.

L'utilisation, et tout particulièrement la réalisation, de tels substrats hybrides, que la couche mixte soit enterrée ou en surface, présente un intérêt tout particulier et ce pour diverses applications, notamment dans les dispositifs de type MOS.

Compte tenu des limitations que rencontrent les dispositifs MOSFET en termes de performances, le changement de l'orientation cristalline de la surface du substrat utilisé (majoritairement Si), tout comme le changement de la direction du canal de conduction des transistors, apparaît comme une solution simple et performante. En effet, de nombreuses études ont démontré l'impact de l'orientation de la surface libre et de la direction du canal de conduction sur les mobilités respectives des trous et d'électrons. Ainsi, une amélioration de la mobilité des porteurs (trous) peut elle être assurée via l'utilisation d'une surface libre d'orientation <110> en comparaison avec une surface libre usuelle de type <100>, comme l'ont récemment rappelé Yang et al. (voir la référence 1 ci-dessous). Toutefois, les technologies CMOS reposent sur l'utilisation simultanée de transistors de type n-MOS (conduction par les électrons) et de type p-MOS (conduction par les trous). En outre, un changement de l'orientation de la surface a des effets antagonistes sur les électrons et sur les trous, nécessitant donc deux orientations de surface libre, différentes pour ces deux types de porteurs. Ainsi il convient de pouvoir produire et faire cohabiter deux types d'orientations sur un même substrat.

On connaît déjà des techniques de réalisation de structures hybrides.

On peut se référer, par exemple, au document WO - 2004/059711 ou à son équivalent US - 2006/0166461, qui proposent la formation d'une structure mixte ou hybride, par collage moléculaire de deux substrats dont l'un comporte en surface deux types de zones différant par leurs matériaux constitutifs ; ces deux types de zones sont, dans ce document, obtenus par des techniques de lithographie, gravure, oxydation thermique en surface et polissage pour ne laisser subsister l'oxyde thermique que dans des zones gravées. Un perfectionnement de cette technique est proposé dans le document EP - 1 923 912, ou son équivalent US - 2008/0079123, qui enseigne la formation d'une couche sacrificielle garantissant la planéité des surfaces finalement mises à nu.

Par ailleurs, le document précité de Yang et al (référence 1), propose, au lieu de la mise en oeuvre d'une oxydation thermique pour remplir les zones gravées, de creuser par gravure des cavités dans un substrat SOI (donc avec une couche semi-conductrice au dessus d'une couche électriquement isolante enterrée), jusqu'au travers de la couche isolante, et de provoquer le remplissage de ces cavités par épitaxie à partir du fond de ces zones gravées, lequel fond est constitué par un matériau (sous cette couche isolante) choisi en sorte d'avoir une cristallographie différente de celle des zones non gravées. Cette technique est commentée plus en détail dans la référence 2. Il est à noter que cette technique est incompatible avec le souhait de disposer d'une couche électriquement isolante enterrée qui est continue, puisqu'elle implique la mise en oeuvre d'une couche d'oxyde qui doit être percée de place en place, en regard de chacune des zones gravées, pour permettre la croissance de zones par épitaxie.

Une autre technique d'élaboration est décrite par Yin et al. (voir la référence 3) ; cette technique est fondée sur l'utilisation d'une structure dite « DSB » (Direct Silicon Bonding), c'est-à-dire obtenue par collage direct de deux substrats de Silicium d'orientations cristallines différentes : par lithographie et implantation d'ions, on amorphise sélectivement des zones de l'un des substrats, sur toute son épaisseur jusqu'à l'interface entre les deux substrats, et on provoque la recristallisation des zones amorphisées suivant la cristallographie de l'autre substrat ;il est en fait mentionné que, à moins de former, avant recristallisation, des tranchées entre les zones amorphisées et les zones non amorphisées, on observe deux phénomènes concurrents de recristallisation, à partir du substrat sous-jacent (selon une première orientation cristallographique) et à partir des zones adjacentes (selon une autre orientation cristallographique). Il est à noter que cette technologie est incompatible avec la présence d'une couche électriquement isolante enterrée le long des zones d'orientations cristallographiques différentes (cette couche interdirait la recristallisation suivant l'orientation cristallographique du substrat sous-jacent).

Yang et al. (voir la référence 4) ont démontré, au travers d'une simulation, l'importance de disposer d'un tel isolant électrique enterré continu sous les zones d'orientations différentes, et ont proposé une modification de leur méthode d'élaboration (telle que définie dans la référence 2) visant à minimiser les interruptions de la couche électriquement isolante enterrée ; cette modification consiste à prévoir que la gravure au travers de la couche électriquement isolante enterrée se fait sur une section inférieure à celle de la cavité creusée dans la couche située au-dessus de cette couche isolante. On comprend néanmoins que cette technique améliorée reste incompatible avec le souhait de disposer d'une couche électriquement isolante enterrée qui est continue.

Il existe donc le besoin de pouvoir élaborer des substrats hybrides comportant, adjacente à une couche électriquement isolante enterrée, une couche mixte formée de zones ayant des orientations cristallographiques prédéfinies (deux orientations différentes, en pratique, mais on comprend qu'il peut être utile, dans certains cas, de pouvoir obtenir qu'une telle couche comporte des zones ayant, de manière prédéfinie, l'une de trois (ou plus) orientations différentes).

On peut noter que les technologies mentionnées ci-dessus concernent l'élaboration de substrats hybrides dont la couche mixte est en surface, mais on comprend qu'il peut également être utile de pouvoir élaborer des substrats hybrides dont la couche mixte est enterrée, sous une autre couche qui est en pratique cristalline. De l'état de la technique est aussi connu de US 2007/0013001 A1 et US 2004/0241958 A1.

L'invention a pour objet un procédé permettant d'élaborer, de manière simple et fiable, un substrat hybride comportant un substrat sous-jacent portant une couche continue électriquement isolante et une couche mixte, adjacente à cette couche continue électriquement isolante, formée de familles de zones monocristallines telles que les zones de chaque famille sont constituées d'un matériau prédéterminé en ayant une cristallographie spécifique (du point de vue orientation cristallographique et/ou du point de vue paramètre de maille), sans impliquer de condition concernant le matériau ou la cristallographie de ce substrat sous-jacent.

L'invention propose ainsi un procédé d'élaboration d'un substrat hybride conforme à la revendication 1.

On peut noter qu'ainsi l'invention enseigne de provoquer la recristallisation de zones amorphes à partir d'une couche de référence qui n'est rapportée, par collage moléculaire, que temporairement. Il est donc possible de choisir, pour la couche continue électriquement isolante et pour le substrat sous-jacent, des matériaux et des cristallographies quelconques tout en ayant, après séparation de la couche de référence, une couche mixte de qualité tout à fait similaire à celle obtenue en suivant l'enseignement de Yin et al (référence 2) ; pourtant il n'est pas nécessaire de prévoir de quelconques interruptions au sein de la couche isolante.

Il est intéressant de noter que, puisque l'on sépare la couche de référence formant germe vis-à-vis du substrat hybride, cette couche de référence peut être utilisée pour un nouveau cycle de formation de substrat hybride (après éventuel traitement de lissage ou au contraire de rugosification de la surface mise à nu par la séparation ; voir ci-dessous).

On comprend que, pour que la couche formant germe ne soit fixée que temporairement, il est avantageux que la séparation de cette couche vis-à-vis de la couche mixte puisse se faire, après recristallisation, par décollement au niveau de l'interface de collage ou par fracture auprès de celle-ci ; c'est pourquoi, de manière avantageuse, soit la tenue mécanique de l'interface est volontairement dégradée, soit la tenue mécanique de la couche formant germe est volontairement dégradée auprès de cette interface de collage (ces options peuvent être combinées). Toutefois, contrairement à ce que l'on pouvait craindre, il est apparu qu'une telle dégradation, ou fragilisation, n'empêche pas la couche de référence d'assurer efficacement son rôle de germe de recristallisation au travers de l'interface.

Une telle dégradation de l'interface de collage, visant à réduire l'énergie de collage malgré la consolidation qui intervient normalement du fait d'un traitement thermique tel que le traitement de recristallisation, peut notamment être assurée par un traitement de rugosification de l'une et/ou l'autre des faces destinées à être collées par collage moléculaire ; pour des raisons pratiques il est avantageux de rugosifier la surface libre d'au moins la couche de référence.

La rugosité ainsi obtenue est avantageusement comprise entre 0.1 nm et 1 nm RMS, par exemple de l'ordre de 0.2nm RMS (par mesure AFM, c'est-à-dire par mesure par force atomique, par exemple sur une surface de 5 microns x 5 microns). Cette rugosification est avantageusement obtenue par une gravure, par exemple, au moins dans le cas d'une couche de silicium monocristallin, dans une solution d'eau, d'ammoniaque et d'eau oxygénée (H₂O, NH₄⁺/OH⁻ et H₂O₂ dans des proportions 1-1-5 à 70°C pendant 15mm (il est à la portée de l'homme de métier de choisir une solution appropriée à chaque matériau à graver).

Au lieu de modifier la rugosité des couches destinées à être collées, on peut prévoir une couche sacrificielle entre ces deux surfaces, sous réserve que cette couche conserve l'information cristalline à transmettre et permette ainsi que la couche formant germe assure son rôle lors de la recristallisation. A titre d'exemple, cette couche sacrificielle peut être un alliage des matériaux constitutifs des zones amorphes et de la couche formant germe, lequel alliage est épitaxié sur la couche formant germe, par exemple du SiₓGe₍₁₋ₓ₎ dans le cas d'une couche mixte en silicium collée à une couche formant germe en silicium ou en germanium. Dans le cas où l'on souhaite recristalliser des portions amorphes de silicium par un germe monocristallin de silicium, il sera possible de déposer sur le germe une couche mince sacrificielle de SiGe. Cette couche devra être d'épaisseur inférieure à l'épaisseur critique (épaisseur jusqu'à laquelle du SiGe croît avec le paramètre de maille du silicium sous-jacent, conservant ainsi l'information cristalline du silicium ; pour du Si_{0,8}Ge_{0,2} sur Si, on se limitera typiquement à une épaisseur de 5nm). Après collage et recuit de recristallisation, pour obtenir la séparation, il suffit alors d'éliminer une grande partie du substrat germe, par exemple par rectification mécanique ou par fracture au niveau d'une zone fragile enterrée réalisée préalablement dans le substrat germe, puis de mettre en oeuvre une ou plusieurs solutions d'attaque sélective de tout type connu approprié pour éliminer la partie du germe résiduelle, s'il en existe, puis la couche sacrificielle de SiGe (une solution connue par exemple pour graver sélectivement le SiGe par rapport au silicium est HF/HNO₃).

Pour faciliter le décollement, on pourra prévoir également de limiter le budget thermique de recristallisation (qui tend en même temps à renforcer l'interface de collage). On peut par exemple prévoir de recristalliser seulement une faible partie des zones amorphes, en pratique une partie de l'épaisseur de celles-ci, à partir de l'interface de collage, pour limiter la durée d'application du traitement de recristallisation, puis de procéder au décollement (tant que l'interface de collage a une tenue modérée) puis de poursuivre et compléter la recristallisation des zones amorphes par l'application d'un budget thermique complémentaire. Cela permet de limiter le budget thermique pré-décollement (et donc de garantir que la structure sera décollable) tout en transférant l'information cristalline « de l'autre coté » de l'interface de collage. Il est rappelé que la notion de budget thermique englobe à la fois la température d'un traitement et sa durée.

Une telle recristallisation en deux étapes de traitement, avec un premier traitement qui n'est adapté à provoquer la recristallisation que d'une partie (en pratique, une partie de l'épaisseur) des zones amorphes et, après séparation, l'application d'un second traitement thermique (voire de plusieurs traitements thermiques) adapté(s) à poursuivre et compléter la recristallisation de ces zones amorphes, a aussi, indépendamment de l'endroit où se fait la séparation, un avantage énergétique puisque le traitement thermique complémentaire n'a pas besoin d'être appliqué à la couche formant germe.

On comprend aisément que, bien que cela soit avantageux, il n'est pas nécessaire que la recristallisation soit obtenue, partout dans les zones à recristalliser, sur une même partie de l'épaisseur de celles-ci ; il suffit que la partie de ces zones qui est recristallisée soit suffisamment importante pour servir de germe au reste de la zone, lors du traitement thermique postérieur à la séparation.

Une manière de dégrader la tenue mécanique de la couche de référence consiste à élaborer au moins une partie de cette couche sous forme poreuse, ou à rendre poreuse au moins une partie de cette couche, après élaboration, à proximité de l'interface. En fait, il n'est pas nécessaire que cette zone poreuse soit exactement adjacente à cette interface, même si cela est avantageux pour permettre une fracture très proche de l'interface. On comprend en effet que, lorsque la séparation se fait à distance de l'interface, des traitements classiques de polissage, mécaniques et/ou chimiques et/ou thermique, permettent d'éliminer le résidu de la couche de référence restant collé au film après fracture dans la couche poreuse.

En variante la fragilisation de la couche de référence peut être réalisée, à une très faible profondeur donnée, par implantation d'ions, conformément à la technique connue sous le nom de « Smart Cut ™ ». Une telle implantation est avantageusement réalisée avant collage, de manière à ce que la fragilisation résultant de l'implantation puisse se développer durant le traitement thermique de recristallisation. La séparation a ensuite lieu au sein de cette couche fragile, à proximité immédiate de l'interface de collage.

Cette couche de référence a de préférence une épaisseur comprise entre quelques nanomètres et plusieurs centaines de microns. Le matériau constitutif de cette couche de référence est avantageusement identique à celui des zones amorphes, ce qui a pour effet que les zones amorphes se recristallisent selon une taille de maille naturelle pour ce matériau. Toutefois, on peut choisir pour cette couche de référence un matériau différent de celui des zones amorphes, lorsque l'on souhaite par exemple recristalliser ces zones amorphes en un état contraint ; le matériau de la couche de référence et celui des zones amorphes comportent avantageusement un élément commun, de sorte que, lorsque le matériau des zones amorphes est le silicium, le matériau de la couche de référence est avantageusement d'un alliage de silicium (par exemple avec du germanium) choisi pour induire l'état de contrainte souhaité (à titre d'exemple, l'utilisation de Si_{0.8}Ge_{0.2} relaxé pour la couche de référence contribue à recristalliser des zones amorphes en silicium contraintes en tension).

La couche mixte est avantageusement réalisée en un seul matériau ayant, selon les zones, l'une ou l'autre des orientations cristallographiques prédéfinies. Il s'agit avantageusement d'une couche mixte en silicium, qui est par exemple, selon les zones, orienté suivant <100> ou <110>. Toutefois, on comprend aisément que la couche mixte peut être réalisée, selon les besoins en un quelconque autre matériau semi-conducteur, tel que le germanium ou l'un de ses alliages avec le silicium, d'autres alliages de silicium tels que du SiC, ou des alliages entre des éléments des colonnes III et V du tableau périodique des éléments (par exemple GaAs), voire des colonnes II et VI, ou encore le carbone, ou le quartz, ou LiTaO₃, LiNbO₃, etc.

Lorsque la couche mixte est réalisée en un même matériau dans les diverses zones, la formation des zones amorphes peut être obtenue en amorphisant des zones au sein d'une couche monocristalline ayant celle des orientations cristallographiques qui n'est pas celle de la couche de référence (à savoir celle qu'auront les premières zones, à la fin de l'élaboration de la couche mixte).

On comprend toutefois que la formation de zones amorphes peut aussi se faire par creusement de cavités dans une couche monocristalline (ayant la cristallographie des futures premières zones) puis remplissage de celles-ci par un nouveau matériau, ce qui a l'intérêt notamment de permettre d'obtenir des couches mixtes dont les zones ont non seulement des orientations cristallines différentes, mais aussi des matériaux constitutifs différents. Le fait de former les zones amorphes par dépôt peut avoir, même lorsqu'elles sont en réalisées dans le même matériau du reste de la couche mixte, pour avantage de conduire à une moindre recristallisation des zones amorphes à partir des zones adjacentes, dans la mesure où la formation des zones amorphes par dépôt induit une bien moins bonne compatibilité cristallographique avec ces zones adjacentes que lorsque l'on procède par amorphisation.

Il est à noter que le dépôt du matériau amorphe peut être réalisé dans un four, sur plusieurs substrats (parfois appelées plaquettes lorsqu'il s'agit d'un disque de quelques dizaines de centimètre de diamètre, par exemple 30cm). Il s'agit donc d'un traitement collectif et bien connu, ce qui conduit à une production fiable et rapide pour un coût modéré.

Les zones de la couche mixte sont avantageusement réalisées, par amorphisation ou par dépôt de matériau amorphe, avec une épaisseur égale à celle de cette couche, de sorte que la surface libre du premier substrat est elle-même mixte. En variante, les premières zones de la couche mixte ne s'étendent, à partir de la couche continue électriquement isolant, que sur une partie de l'épaisseur de cette couche mixte, le matériau amorphe étant situé non seulement de manière adjacente à ces premières zones, mais aussi au-dessus de celles-ci ; puisque le matériau amorphe s'étend ainsi au-dessus des premières zones et des secondes zones, il s'étend de manière continue le long de toute la surface libre du premier substrat ; une telle configuration correspond à un cas où le premier substrat est formé à partir d'une première couche formée du matériau des premières zones, où on creuse des cavités sur toute l'épaisseur de cette première couche et on dépose un matériau amorphe dans ces cavités pour former les secondes zones et sur une épaisseur donnée au-dessus de l'ensemble des premières et secondes zones.

De manière avantageuse, la couche continue électriquement isolante sous-jacente est en un oxyde, de préférence en un oxyde d'un matériau de la couche mixte, par exemple un oxyde du matériau constitutif des zones amorphes ; il peut s'agir d'un oxyde déposé sur un substrat sous-jacent, mais aussi d'un oxyde thermique formé à partir de ce dernier. C'est ainsi que cette couche est avantageusement en oxyde de silicium. De manière générale, le matériau de cette couche continue électriquement isolante peut être choisi dans une large gamme de matériaux de la micro-technologie, du moment qu'il est compatible avec les étapes de recristallisation (oxydes, voire nitrures, HfO₂, etc.) ; il peut s'agir d'une couche homogène ou d'une pluralité de couches élémentaires (identiques ou différentes).

Cette couche continue électriquement isolante a avantageusement une épaisseur comprise entre quelques nanomètres et plusieurs microns. On comprend aisément que, si cette couche est suffisamment épaisse, elle peut ne pas avoir besoin d'être supportée par un substrat sous-jacent et peut constituer en elle-même un substrat porteur pour la couche mixte.

Il a été mentionné que le collage moléculaire est réalisé de manière hydrophobe. C'est en effet la meilleure façon (voire la seule) d'obtenir une bonne transmission, complète, de l'information cristalline au travers de l'interface de collage ; il a par contre été constaté que, si l'une des surfaces est hydrophile, l'oxyde présent à l'interface empêche une bonne transmission de cette information cristalline.

De manière avantageuse, le traitement thermique de recristallisation est effectué à une température comprise entre 200°C, et 1300°C, de préférence entre 350°C et 1200°C, selon les matériaux mis en oeuvre : la durée du traitement est typiquement comprise, selon ces matériaux, entre quelques fractions de secondes et quelques heures (notamment dans le cas du silicium amorphe).

La séparation de la couche de référence formant germe, vis-à-vis de la couche mixte au moins en partie recristallisée, peut être effectuée par l'insertion mécanique d'un outil (par exemple une lame), ou d'un fluide (notamment, gaz ou eau), ou par des ondes acoustiques, au moins au sein de la zone fragile constituée par (ou dans) la couche formant germe (lorsqu'elle est poreuse, au moins en partie, ou qu'on y a implanté des ions) ou par l'interface de collage (lorsque son énergie de collage est faible).

Après la séparation entre la couche mixte en partie recristallisée et la couche formant germe, on applique avantageusement un recuit thermique à cette couche mixte afin d'en éliminer les éventuels défauts cristallins encore présents (ce recuit est avantageusement réalisé à une température supérieure à la température à laquelle la recristallisation a été effectuée).

Des étapes de finition peuvent être utiles pour la structure ainsi obtenue, afin d'obtenir notamment un bon état de surface en termes de rugosité, par exemple. Il peut ainsi s'agir d'étapes telles qu'un polissage mécano-chimique, des recuits sous atmosphère réductrice, sous vide...

Dans ce qui précède il a été implicitement indiqué que la couche formant germe était continue et homogène. Cela n'est pas nécessaire pour la mise en oeuvre de l'invention. C'est ainsi que l'invention peut être mise en oeuvre avec une couche formant germe constituée par une couche discontinue composée de nanofils (c'est-à-dire des fils dont le diamètre est de l'ordre de grandeur du nanomètre, ou de quelques nanomètres, typiquement inférieur à 5 nanomètres), par exemple des nanofils de silicium entourés d'oxyde de silicium, ou encore en SiₓGe₍₁₋ₓ₎.

A titre d'exemple, dans le cas de couches formées de silicium, les nanofils de silicium sont avantageusement élaborés sur un substrat de silicium monocristallin de manière à ce qu'ils aient tous la même information cristalline (cf: « Kuiqing Peng, Ying Xu, Yin Wu, Yunjie Yan, Shuit-Tong Lee and Jing Zhu, small 2005, 1, N°11, 1062-1067 »). Le procédé mis en oeuvre est par exemple celui décrit dans :
- Allon I. Hochbaum, Rong Fan, Rongrui He and Peidong Yang, NANO LETTERS 2005, Vol 5, N°3, pp 457-460,
- Kuiqing Peng, Juejun Hu, Yunjie Yan, Yin Wu, Hui Fang, Ying Xu, Shuit-Tong Lee and Jing Zhu, Adv. Funct. Mater. 2006, 16, 387-394.

De préférence, on dépose ensuite une couche d'oxyde sur l'ensemble des nanofils et, après une étape de polissage mécano-chimique, on obtient une surface composée d'oxyde et de silicium cristallin comme expliqué dans « Volker Schmidt, Heike Riel, Stephan Senz, Siegfried Karg, Walter Riess, and Ulrich Gösele, small 2006, 2, n°1, 85-88 ». On procède ensuite au collage hydrophobe sur une couche, de silicium par exemple, au moins en partie amorphe, puis à un recuit de recristallisation. La séparation s'effectue ensuite au sein de la couche composite oxyde/nanofil, de préférence, de façon mécanique et/ou chimique (dissolution de l'oxyde dans du HF par exemple). Afin de faciliter la séparation, il est possible de remplacer l'oxyde de silicium qui est autour des nanofils par une couche présentant une plus faible résistance mécanique, par exemple en HfO₂ ou un bicouche composé de HfO₂ et d'oxyde de silicium (la couche supérieure d'oxyde de silicium permettant de faciliter le polissage mécano-chimique pour l'obtention d'une surface plane nécessaire au collage moléculaire).

Comme indiqué précédemment à propos des couches formant germe, les nanofils peuvent être, non pas en silicium, mais en un autre matériau tel que le germanium si l'on veut recristalliser du germanium (selon la cristallographie habituelle du germanium).

Il est aussi possible de faire croître du Si₍₁₋ₓ₎Geₓ (x=0.2, par exemple) sur le sommet des nanofils de silicium, ce qui a notamment pour avantage d'obtenir du Si₍₁₋ₓ₎Geₓ avec un paramètre de maille relaxé et sans contrainte au sein du nanofil. Lors de la recristallisation des zones amorphes (par exemple du silicium), c'est le paramètre des nanofils qui sert de germe, ce qui permet d'obtenir, après recristallisation et après séparation, un silicium avec un paramètre de maille correspondant à du Si(1-x)Gex, donc avec une contrainte interne.

On comprend que l'intérêt d'utiliser des nanofils, plutôt qu'une couche homogène, pour former la couche formant germe est que la présence de plusieurs matériaux peut faciliter la séparation. Les nanofils permettent également de disposer facilement de matière relaxée.

Des objets, caractéristiques et avantages de l'invention ressortent de la description qui suit, donnée à titre illustratif non limitatif, en regard des dessins annexés sur lesquels :
- la figure 1 est une vue en coupe d'un premier substrat destiné à l'élaboration d'un substrat hybride selon l'invention,
- la figure 2 en est une vue en coupe, après une première étape de préparation, selon un premier mode de réalisation,
- la figure 3 en est une vue en coupe après une seconde étape de préparation, selon ce premier mode de réalisation,
- la figure 4 est une vue en coupe d'un assemblage temporaire de ce premier substrat, selon ce premier mode de réalisation, avec un second substrat,
- la figure 5 est une vue en coupe de cet assemblage après une étape de recristallisation et une étape de séparation du premier substrat vis-à-vis du second substrat,
- la figure 6 est une vue en coupe d'un premier substrat similaire à celui de la figure 1 après une première étape de préparation selon un second mode de réalisation,
- la figure 7 en est une vue en coupe après une seconde étape de préparation, selon ce second mode de réalisation,
- la figure 8 est une vue en coupe d'un assemblage temporaire de ce premier substrat, selon ce second mode de réalisation, avec un second substrat,
- la figure 9 en est une vue en coupe après une étape de recristallisation et une étape de séparation,
- la figure 10 est une vue en coupe d'encore un autre premier substrat, après une première étape de préparation selon un troisième mode de réalisation,
- la figure 11 en est une vue en coupe après une seconde étape de préparation, selon ce troisième mode de réalisation,
- la figure 12 en est une vue en coupe après une troisième étape de préparation, selon ce troisième mode de réalisation,
- la figure 13 est une vue en coupe d'un assemblage de ce premier substrat, selon ce troisième mode de réalisation, à un second substrat,
- la figure 14 est une vue de cet assemblage après une étape de recristallisation et une étape de séparation,
- la figure 15 en est une vue en coupe après une étape optionnelle d'amincissement,
- la figure 16 est une vue schématique en coupe d'un autre assemblage, selon une variante de réalisation, et
- la figure 17 en est une vue après une étape de séparation selon un autre mode de réalisation.

### Premier exemple de réalisation

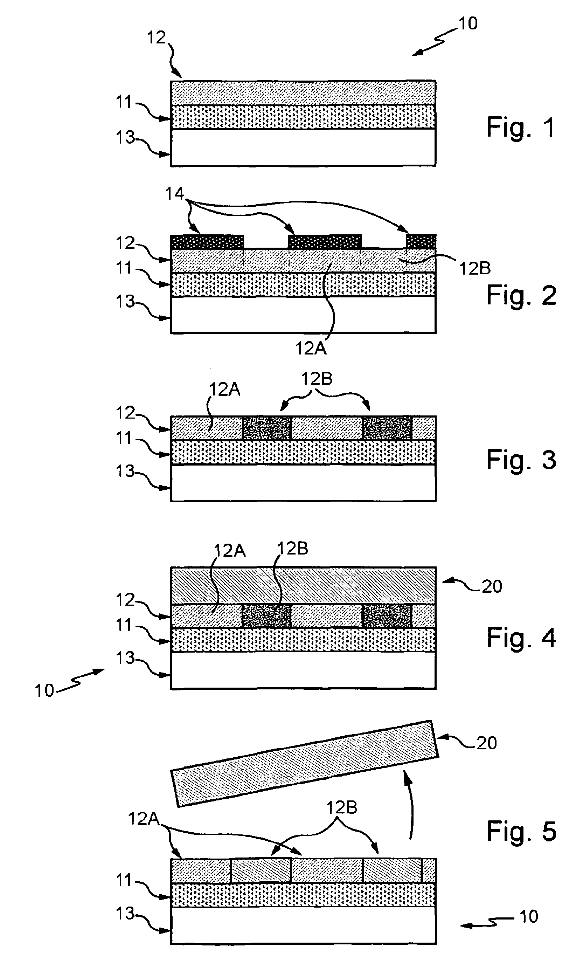

Les figures 1 à 5 illustrent un premier mode de mise en oeuvre de l'invention, qui est particulièrement simple.

On part d'un substrat de départ 10 comportant (voir la figure 1) une couche continue électriquement isolante 11 et une couche monocristalline 12 orientée suivant une orientation prédéterminée.

La couche monocristalline 12 a ici une épaisseur inférieure au micron, par exemple de l'ordre de 60 nm.

La couche continue 11 étant également, dans l'exemple ici considéré, d'une épaisseur inférieure à un micron (de l'ordre de 600 nm) elle est elle-même supportée par un substrat porteur (ou sous-jacent) 13.

Dans l'exemple considéré, le substrat porteur est en silicium, polycristallin (mais il apparaîtra plus loin que le matériau constitutif de ce substrat porteur n'a pas de rôle dans la mise en oeuvre de l'invention, pas plus que ses caractéristiques cristallines) ; par ailleurs, la couche continue 11 est en oxyde de silicium, par exemple réalisé par oxydation thermique du substrat porteur 13 ; quant à la couche 12, elle est ici également en silicium, suivant une orientation prédéterminée, à savoir <100>.

Un tel premier substrat 10 peut être analysé comme étant une structure de type SOI ; initialement cette abréviation désignait une structure comportant du silicium sur de l'isolant (en anglais Silicon On Insulator), mais, compte tenu du développement de l'utilisation d'autres matériaux dans la micro-technologie, cette abréviation désigne couramment, désormais, un semi-conducteur sur un isolant (en anglais, Semiconductor on Insulator).

Une première étape de préparation de ce substrat est schématisée à la figure 2, avec le dépôt d'un masque discontinu 14 destiné à délimiter dans la couche 12 de premières zones masquées 12A et de secondes zones non masquées 12B.

La figure 3 schématise une seconde étape de préparation du substrat 10 consistant à amorphiser, par implantation locale d'ions, les zones non masquées 12B de la figure 2.

On comprend que la formation du masque 14 peut être réalisée en plusieurs étapes élémentaires, tout à fait à la portée de l'homme de métier. De manière générale on peut dire que la formation de ce masque est obtenue par des opérations de micro-lithographie connues en soi. Il s'agit avantageusement d'opérations de masquage par photolithographie.

Après l'élimination du masque 14 (voir la figure 3), le substrat 10 comporte une couche mixte 12 qui est longée par une couche sous-jacente continue 11 électriquement isolante et qui est formée de premières zones monocristallines 12A en au moins un premier matériau cristallin et de secondes zones 12B adjacentes en un second matériau sous forme amorphe, ces secondes zones formant au moins une partie de la surface libre de ce premier substrat. Dans l'exemple considéré, les premières et secondes zones sont en un seul et même matériau, à savoir en silicium.

En fait, puisque les zones 12A et 12B s'étendent sur toute l'épaisseur de la couche 12, la même mixité peut ici s'observer à l'interface avec la couche sous-jacente et en surface.

On assemble ensuite (voir la figure 4) ce premier substrat 10 à un second substrat 20 par collage moléculaire hydrophobe sur au moins ces zones amorphes, le second substrat comportant en surface une couche de référence ayant une orientation cristallographique donnée. Dans l'exemple ici considéré, le substrat 20 est homogène et monocristallin, de sorte qu'il forme dans son ensemble une couche de référence ayant une orientation cristallographique donnée. Toutefois, en variante non représentée, la couche de référence est limitée, en épaisseur, à une portion de ce substrat longeant la surface libre (orientée vers le bas à la figure 4), ce qui permet que le reste du substrat 20 soit en un matériau quelconque, monocristallin ou polycristallin, d'orientation cristallographique quelconque.

Cette couche est avantageusement constituée du même matériau que celui des zones amorphes 12B, ici du silicium. Plus généralement, il est en un matériau ayant des paramètres cristallographiques (notamment du point de vue orientation et taille de maille) compatibles avec les configurations cristallographiques possibles du matériau amorphe. Le plus souvent, un élément et son oxyde n'ont pas des cristallographies compatibles, notamment dans le cas du silicium.

Dans l'exemple de réalisation décrit, la couche de référence est un substrat (typiquement de 725µm d'épaisseur) Cette couche de référence a une orientation cristallographique différente de celle des zones 12A, correspondant, dans l'exemple considéré, à <110>.

On applique ensuite, à au moins la couche de référence et à la couche mixte (en pratique à l'ensemble de l'assemblage 10+20), un traitement thermique propre à provoquer la recristallisation du matériau amorphe qui constitue les zones 12B (voir la figure 5). Grâce au collage moléculaire établi à l'interface entre les zones amorphes et la couche de référence, cette recristallisation se fait suivant les paramètres cristallographiques de la couche de référence plutôt qu'avec ceux de la couche sous-jacente en oxyde ; en fait, il peut y avoir un phénomène concomitant de recristallisation des zones amorphes à partir des interfaces avec les zones 12A restées cristallines, mais celui-ci est généralement modéré compte tenu des dimensions réelles des zones amorphes (leur épaisseur est, sur les dessins, très exagérée par rapport à leur largeur parallèlement à la couche continue).

Les zones 12B recristallisent donc suivant l'orientation de la couche de référence, à savoir suivant l'orientation <110> alors que les zones adjacentes ont conservé l'orientation <100> d'origine.

Ce recuit peut consister par exemple en une rampe de température de 0,5°C/mn entre 200°C et 1200°C.

On provoque enfin, par tout moyen connu approprié, la séparation du premier substrat, dont les zones 12B sont désormais recristallisées, vis-à-vis du second substrat (voir également la figure 5).

Cette séparation est ici réalisée par décollement de l'interface de collage, ce qui suppose d'avoir effectué le collage d'une manière conduisant à une tenue mécanique suffisante pour garantir que la couche de référence agit comme un germe de recristallisation lors du traitement thermique, mais suffisamment faible pour permettre, après cette recristallisation, une séparation sans dégrader les substrats, en particulier la couche mixte 12. Il faut rappeler ici qu'un traitement de recristallisation est un traitement thermique qui est en pratique à une température suffisamment élevée pour tendre à consolider le collage moléculaire, de sorte qu'il faut en tenir compte pour définir le compromis des conditions opératoires du collage moléculaire.

Plusieurs types de traitement (chimique, thermique, plasma, mécanique, etc...) sont à la portée de l'homme de métier pour préparer la surface de la couche de référence et celle de la couche mixte pour les rendre compatibles, des points de vue planéité, rugosité et nature chimique, avec une telle étape de collage moléculaire hydrophobe conduisant à une interface « démontable ».

On procède ensuite, de manière optionnelle, à un traitement de surface (chimique et/ou thermique et/ou mécanique, etc.) pour adapter la surface mise à nu par le démontage de l'interface à la suite du traitement que le substrat hybride est destiné à se voir appliquer.

Ce traitement de surface peut, en variante non représentée, être remplacé par un traitement d'amincissement visant à réduire l'épaisseur de la couche mixte, ou du substrat porteur.

D'autres opérations optionnelles peuvent être appliquées, telles que la formation de tranchées (voir la référence 3) entre les zones 12A et 12B, avant ou après l'amorphisation (voire avant ou après la recristallisation).

Le substrat 10 de la figure 1 est ainsi devenu un substrat hybride, permettant notamment la production simultanée de transistors à effet de champ de type nFET (sur les zones d'orientation <100>) et pFET (sur les zones d'orientation <110>).

On comprend aisément que l'on peut, de manière analogue, préparer un substrat hybride ayant, non pas deux familles, mais trois (voire plus) familles de zones ayant chacune une orientation cristallographique donnée.

Le recuit thermique de recristallisation peut, en variante, être effectué en deux étapes (voire plus), dont une première étape suffisante pour provoquer la recristallisation d'une partie, éventuellement faible, de l'épaisseur des zones amorphes à partir de l'interface. Après séparation, la recristallisation du reste de la couche amorphe peut être obtenue, en une ou plusieurs étapes, en utilisant les parties recristallisées comme germe pour ce reste des zones amorphes. La première étape est par exemple une rampe plus rapide que celle mentionnée ci-dessus.

Selon encore une autre variante, la couche formant germe est préalablement fragilisée par une implantation d'ions appropriée, de manière à localiser la future séparation.

### Second exemple de réalisation

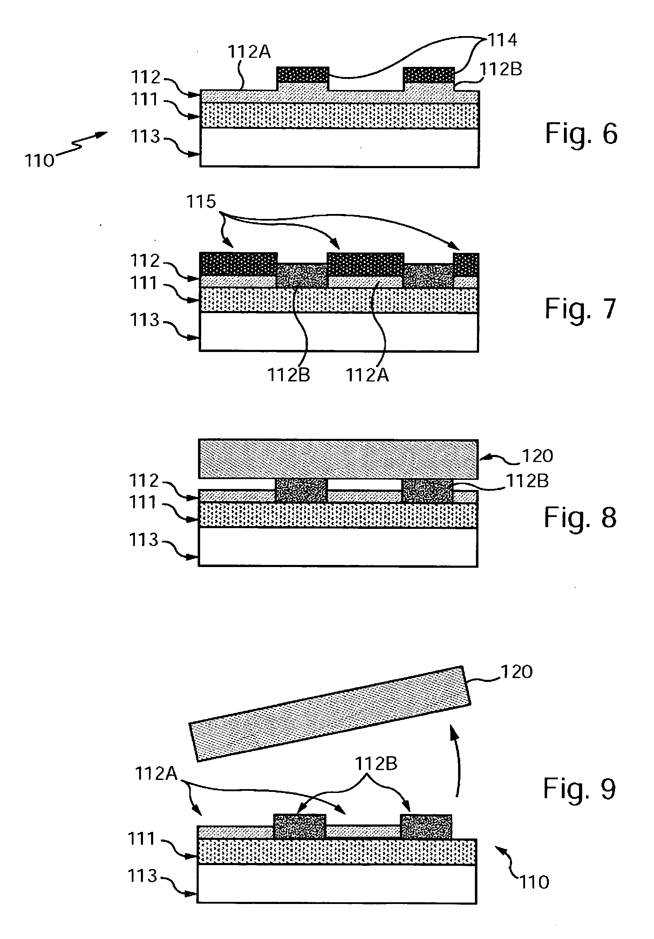

Les figures 6 à 9 schématisent un second exemple de mise en oeuvre du procédé de l'invention.

Sur ces figures, les éléments analogues à ceux des figures 1 à 5 sont désignés par des signes de référence qui se déduisent de ceux utilisés sur ces figures 1 à 5 par l'addition du nombre 100.

On part, comme dans le premier exemple, d'un substrat 110 de type SOI, formé d'une couche continue électriquement isolante 111 sur un substrat porteur 113, et d'une couche monocristalline 112. Ce substrat 110 a les mêmes dimensions et les mêmes natures de couche que le substrat 10 ; il est ainsi formé d'un substrat porteur en silicium, par exemple polycristallin, recouvert d'une couche de SiO2, elle-même recouverte d'une couche monocristalline de silicium d'orientation <100>.

A la différence de la figure 2, la première étape de préparation schématisée à la figure 6 comporte la formation d'un premier masque discontinu 114 recouvrant des zones 112B destinées à changer de cristallographie ; en outre, cette première étape comporte un amincissement des zones non masquées 112A. Bien entendu, cet amincissement, qui correspond à la figure 6 à une réduction d'environ la moitié de l'épaisseur initiale de la couche 112, peut être plus modéré.

La figure 7 schématise une seconde étape de préparation correspondant à celles des figures 2 et 3, c'est-à-dire une étape selon laquelle, en combinaison avec l'élimination du masque 114, on forme un deuxième masque discontinu 115 recouvrant les zones 112A destinées à conserver leur orientation cristalline et on amorphise les zones non masquées ; compte tenu de la première étape de la figure 6, l'amorphisation est effectuée sur une épaisseur (l'épaisseur initiale de la couche 112) qui est supérieure à l'épaisseur des zones masquées 112A. On procède ensuite au retrait du masque 115 ; ces diverses étapes de micro-lithographie sont, en soi, bien connues de l'homme de métier.

A ce stade, le premier substrat comporte des zones amorphisées 112B qui sont en saillie vis-à-vis de zones 112A restées intactes du point de vue cristallographique.

On comprend qu'ainsi (voir la figure 8), la mise en contact du premier substrat 110 avec un second substrat 120 (d'orientation <110>), ici identique à celui du premier exemple de mise en oeuvre de l'invention, ne se fait que par l'intermédiaire de la surface libre de ces zones amorphisées ; on évite ainsi d'éventuelles réactions parasites au niveau des surfaces en regard des premières zones 112A et de la couche de référence 120.

Après l'application d'un traitement de recuit propre à provoquer la recristallisation des zones amorphisées, la mise en oeuvre du procédé de l'invention suivant ce second exemple comporte une étape de séparation, par tout moyen approprié, du second substrat vis-à-vis du premier substrat (voir la figure 9).

On peut alors effectuer les mêmes opérations optionnelles que dans le premier exemple. En pratique, il est recommandé de procéder à un polissage (ou tout autre traitement lissant, par exemple un recuit sous H2, un recuit sous vide...) visant à rattraper la différence de niveau entre les surfaces libres des zones 112A et 112B ; toutefois, il est possible que cette différence puisse être mise à profit, par exemple pour l'élaboration de tout ou partie de composants.

Ainsi, ce second exemple de mise en oeuvre de l'invention se distingue du premier exemple par le fait que le collage moléculaire hydrophobe est limité aux zones à recristalliser, ce qui tend à protéger les zones devant conserver leur cristallographie.

Comme dans le premier exemple, le recuit de recristallisation peut être réalisé en deux étapes séparées par l'étape de séparation.

### Troisième exemple de réalisation

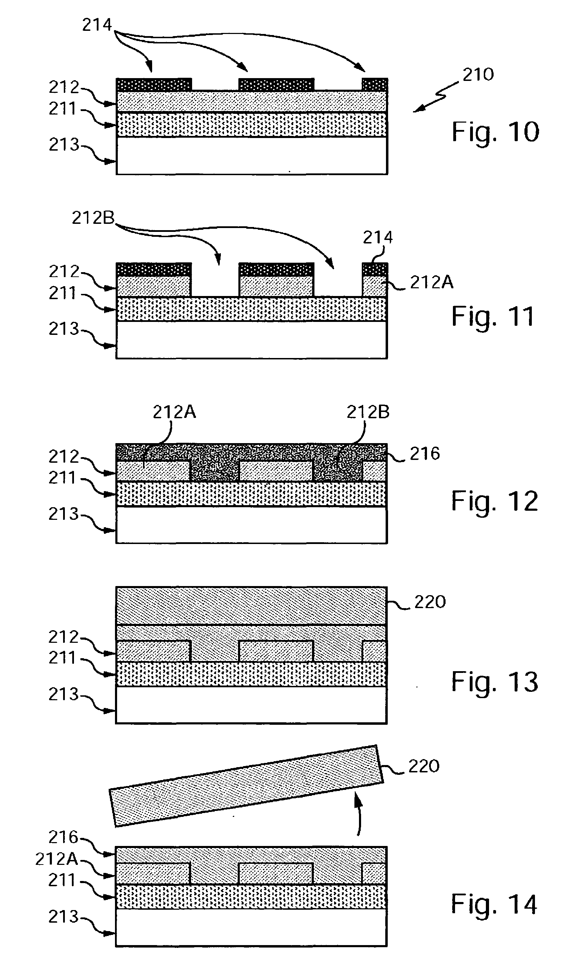

On peut noter que, selon les premier et second exemples de mise en oeuvre, on part d'un premier substrat de type SOI, dont la couche supérieure a la cristallographie d'une des familles de zones que l'on veut former dans la couche mixte ; la formation des zones amorphes y est effectuée par amorphisation d'une partie de cette couche supérieure. Les figures 10 à 14 représentent un troisième exemple de mise en oeuvre de l'invention mettant en oeuvre un autre type de formation de zones amorphes.

Dans ce troisième exemple de mise en oeuvre, les éléments similaires à ceux utilisés à propos du premier exemple sont désignés par des signes de référence qui se déduisent de ceux de ce premier exemple par addition du nombre 200.

C'est ainsi que, dans ce troisième exemple de mise en oeuvre, on part d'un substrat de départ 210 comportant une couche continue électriquement isolante 211 portée par un substrat porteur 213 et surmontée par une couche monocristalline 212. Il s'agit avantageusement d'un substrat de type SOI identique à celui utilisé dans les premier et second exemples.

La figure 10 est similaire à la figure 2, la couche 212 étant recouverte par un masque discontinu 214.

A la différence des premier et second exemples, le masque 214 est utilisé, non pas pour amorphiser sélectivement des zones de la couche d'origine, mais pour creuser cette couche, à l'emplacement des zones 212B non masquées, jusqu'à la couche continue 211 (voir la figure 11), au moyen d'une gravure par une solution de tout type connu approprié.

Cette étape de gravure est suivie d'une étape (voir la figure 12) de dépôt d'un matériau amorphe en sorte de remplir les cavités 212B ; dans l'exemple schématisé ici, le dépôt du matériau amorphe est poursuivi jusqu'à, non seulement remplir les cavités formées lors de l'étape de la figure 11, mais aussi former un film continu 216 recouvrant la totalité de la couche 212 initiale ; la surface libre du premier substrat est alors entièrement constituée du matériau amorphe.

Dans la mesure où les zones amorphes sont formées par dépôt d'un matériau, celui-ci peut, à la différence des premier et second exemples, être différent de celui de la couche 212 d'origine. Toutefois, dans l'exemple ici considéré, ce matériau est du silicium, comme dans ces exemples précédents.

Comme précédemment, des étapes optionnelles de préparation de la surface libre du premier substrat sont effectuées, de tout type approprié (chimique, thermique, plasma, mécanique, etc...) en sorte de rendre cette surface libre du premier substrat compatible avec un collage moléculaire hydrophobe démontable (voir la figure 13) avec un second substrat 220 comportant au moins en surface un matériau de référence adapté à former un germe de recristallisation lors d'un traitement ultérieur de recristallisation du matériau amorphe (voir cette figure 13).

On comprend que l'obtention d'un bon contrôle de la tenue mécanique de l'interface entre les deux substrats est ici facilitée par le fait que, au niveau de cet interface de collage, le premier substrat est entièrement formé d'un unique matériau homogène.

Comme précédemment on procède ensuite au démontage de l'interface de collage par tout moyen approprié (voir la figure 14) ; on peut alors effectuer d'éventuelles étapes de finition, comme dans les exemples précédents.

A la différence des exemples précédents, la mise en oeuvre de ce troisième exemple aboutit à la formation d'une couche mixte comportant, le long de la couche continue électriquement isolante, une alternance de zones monocristallines ayant des orientations cristallographiques différentes, tandis qu'il y a une unique orientation cristallographique le long de la surface mise à nu par la séparation. En d'autres termes, la couche mixte comporte des familles de zones qui ont des épaisseurs différentes, ici respectivement définies par l'épaisseur de la couche 212 d'origine et par l'épaisseur maximale de dépôt de matériau amorphe.

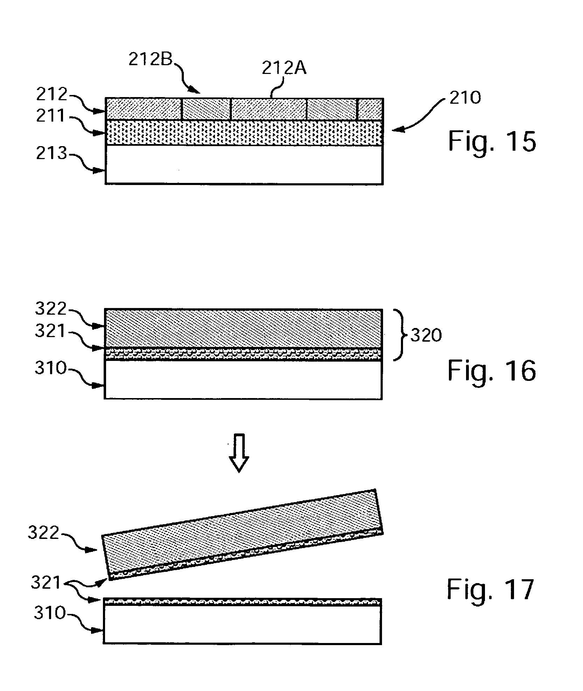

En fonction des besoins, une étape optionnelle d'amincissement peut être effectuée en sorte d'aboutir à une couche mixte dans laquelle les zones d'orientations cristallographiques différentes s'étendent sur la même épaisseur (voir la figure 15).

On notera que, en variante de ce troisième exemple de mise en oeuvre, une étape de fragilisation, typiquement par bombardement ionique (selon la technologie « Smart Cut ™ » par exemple) peut être effectuée au sein même de la couche continue 216 surmontant les zones initiales 212A, ce qui permet d'éviter à devoir éliminer par polissage cette couche continue.

Comme précédemment, la recristallisation peut se faire en plusieurs étapes.

### Variante de séparation

Les exemples précédents mettent en oeuvre un collage démontable, dont la tenue mécanique est donc contrôlée en sorte de pouvoir se séparer, malgré la consolidation résultant du traitement de recuit nécessaire pour la recristallisation.

Les figures 16 et 17 illustrent une variante de l'étape de séparation (et donc de la préparation du second substrat).

La figure 16 illustre une étape consistant à fragiliser le second substrat 320 à proximité immédiate de la surface libre de celui-ci qui est destinée à être collée au premier substrat, représenté sous la référence 310 (il peut s'agir de l'un quelconque des premiers substrats des exemples précédents). Le résultat de cette fragilisation est schématisé par une couche 321 qui longe cette surface libre. Il s'agit avantageusement d'une couche poreuse.

Cette couche poreuse peut être formée, sur une épaisseur donnée du second substrat à partir de sa surface libre, par exemple par exposition à un électrolyte à base de HF sous polarisation extérieure. Ce traitement est avantageusement effectué avant la mise en contact et le collage moléculaire hydrophobe du second substrat avec le premier substrat.

Après le recuit de recristallisation (lequel peut avoir modifié cette porosité), on provoque la séparation au sein de cette couche poreuse, par exemple par insertion d'un outil tel qu'une lame, ou par injection d'un fluide sous forte pression.

On obtient alors la configuration de la figure 17, suite à quoi un traitement de polissage de tout type connu approprié permet de mettre à nu l'interface de collage. Toutefois, il peut être admis, selon les applications, de conserver une partie de la couche poreuse, ou au contraire de poursuivre le polissage jusqu'à amincir la couche mixte.

On appréciera que le second substrat peut être réutilisé pour de nouveaux cycles de recristallisation ; cela est vrai dans les premier et second exemples où la séparation se fait à l'interface de collage, mais aussi dans le troisième exemple, puisque seule une faible épaisseur est consommée à chaque cycle de recristallisation.

### Bibliographie

Référence 1 : « High Performance CMOS Fabricated on Hybrid Substrate With Different Crystal Orientations » de Yang, leong, Shi, Chan, Chan, Chou, Gusev, Jenkins, Boyd, Ninomiya, Pendleton, Surpris, Heenan, Ott, Guarini, D'Emic, Cobb, Mooney, To, Rovedo, Benedict, Mo, Ng, paru dans IEDM 03 - 2003 pp 453-456,
Référence 2 : "Hybrid-Orientation Technology (HOT): Opportunities and Challenges" de Yang, Chan, Chan, Shi, Fried, Stathis, Chou, Gusev, Ott, Burns, Fischetti, leong paru dans IEEE Transaction on Electron Devices, Vol. 53, N° 5, May 2006, pp965-978,
Référence 3 : "Direct Silicon Bonded (DSB) Substrate Solid Phase Epitaxy (SPE) Integration Scheme Study for High Performance Bulk CMOS" de Yin, Sung, Ng, Saenger, Chan, Crowder, Zhang, Li, Ott, Pfeiffer, Bendernagel, Ko, Ren, Chen, Wang, Liu, Cheng, Mesfin, Kelly, Ku, Luo, Rovedo, Fogel, Sadana, Khare, Shahidi, paru dans 1-4244-0439-8/06/$20.00 © 2006 IEEE,
Référence 4 : "Silicon-on-Isolator MOSFETs with Hybrid Crystal Orientations" de Yang, Chan, Kumar, Lo, Sleight, Chang, Rao, Bedell, Ray, Ott, Patel, D'Emic, Rubino, Zhang, Shi, Steen, Sikorski, Newbury, Meyer, To Kozlowski, Graham, Maurer, Medd, Canaperi, Deligianni, Tornello, Gibson, Dalton, leong, Shabidi paru dans Symposium on VLSI Technology Digest of Technical Papers, 2006.

## Revendications

1. Procédé d'élaboration d'un substrat hybride selon lequel :
a) on prépare un premier substrat (10,110,210) comportant une couche mixte qui est longée par une couche sous-jacente continue électriquement isolante et qui est formée de premières zones monocristallines (12A,112A,212A) en au moins un premier matériau cristallin et de secondes zones adjacentes en un second matériau sous forme amorphe (12B,112B,212B) ces secondes zones formant au moins une partie de la surface libre de ce premier substrat,
b) on colle à ce premier substrat, par collage moléculaire, sur au moins ces zones amorphes, un second substrat (20,120,220) comportant en surface une couche de référence ayant une orientation cristallographique donnée,
c) on applique au moins à la couche mixte un traitement thermique adapté à provoquer la recristallisation en phase solide d'au moins une partie des zones amorphes (12B,112B,212B) suivant l'orientation cristallographique de la couche de référence (20,120,220), cette couche de référence agissant en tant que germe de recristallisation au travers de l'interface de collage, et
d) on provoque une séparation entre la couche de référence du second substrat et les zones au moins en partie recristallisées du premier substrat
**caractérisé en ce que** :
• le collage moléculaire est un collage moléculaire hydrophobe,
• avant l'étape b), le procédé comporte la rugosification d'au moins l'une des faces, du premier ou du second substrat, destinées à être collées par le collage moléculaire, conduite de manière à ce que la rugosité obtenue soit comprise entre 0.1 nm et 1nm RMS ce qui permet de réduire l'énergie de collage malgré la consolidation qui intervient normalement du fait du traitement thermique de l'étape c), et
• la séparation est réalisée au sein d'une zone fragile constituée par l'interface de collage moléculaire entre les premier et second substrats.

2. Procédé selon la revendication 1, **caractérisé en ce que** le matériau constitutif de cette couche de référence est identique à celui des zones amorphes.

3. Procédé selon la revendication 1, **caractérisé en ce que** le matériau constitutif de la couche de référence et celui des zones amorphes comportent un élément commun.

4. Procédé selon l'une quelconque des revendications 1 à 3, **caractérisé en ce que** la couche mixte est réalisée en un seul matériau ayant, selon les zones, des orientations cristallographiques prédéfinies.

5. Procédé selon la revendication 4, **caractérisé en ce que** les secondes zones sont obtenues par amorphisation d'une couche monocristalline ayant initialement l'orientation cristallographique des premières zones.

6. Procédé selon l'une quelconque des revendications 1 à 3, **caractérisé en ce que** les secondes zones sont formées par creusement d'une couche monocristalline ayant initialement l'orientation cristallographique des premières zones et par dépôt dans les cavités ainsi creusées du second matériau sous forme amorphe.

7. Procédé selon la revendication 6, **caractérisé en ce que** le dépôt du matériau amorphe est effectué jusqu'à former une couche recouvrant les premières zones.

8. Procédé selon l'une quelconque des revendications 1 à 7, **caractérisé en ce que** les premières et secondes zones sont en silicium et la couche continue électriquement isolante est en oxyde de silicium.

9. Procédé selon l'une quelconque des revendications 1 à 8, **caractérisé en ce que** le traitement thermique de recristallisation n'est adapté à provoquer la recristallisation que d'une partie des zones amorphes et, après séparation, on applique un second traitement thermique adapté à compléter la recristallisation de ces zones amorphes.

10. Procédé selon l'une quelconque des revendications précédentes, dans lequel la séparation se fait par insertion mécanique d'un outil ou d'un fluide ou par des ondes acoustiques au sein de la zone fragile.

## Patentansprüche

1. Verfahren zum Verarbeiten eines Hybridsubstrats, in dem:
a) ein erstes Substrat (10, 110, 210) angefertigt wird, das eine Mischschicht umfasst, längs derer eine elektrisch isolierende, ununterbrochene darunter liegende Schicht verläuft und die aus ersten monokristallinen Zonen (12A, 112A, 212A) aus wenigstens einem ersten kristallinen Material und aus zweiten benachbarten Zonen aus einem zweiten Material in amorpher Form (12B, 112B, 212B) gebildet ist, wobei diese zweiten Zonen wenigstens einen Teil der freien Oberfläche dieses ersten Substrats bilden,
b) auf dieses erste Substrat durch molekulares Kleben wenigstens in diesen amorphen Zonen ein zweites Substrat (20, 120, 220) geklebt wird, das auf der Oberfläche eine Referenzschicht aufweist, die eine gegebene kristallographische Orientierung hat,
c) wenigstens auf die Mischschicht eine thermische Bearbeitung angewendet wird, die dafür ausgelegt ist, die Rekristallisation in der festen Phase wenigstens eines Teils der amorphen Zonen (12B, 112B, 212B) längs der kristallographischen Orientierung der Referenzschicht (20, 120, 220) hervorzurufen, wobei diese Referenzschicht als Rekristallisationskeim durch die Klebegrenzfläche hindurch wirkt, und
d) eine Trennung zwischen der Referenzschicht des zweiten Substrats und den wenigstens teilweise rekristallisierten Zonen des ersten Substrats hervorgerufen wird,
**dadurch gekennzeichnet, dass**:
• das molekulare Kleben ein hydrophobes molekulares Kleben ist,
• das Verfahren vor dem Schritt b) das Aufrauen wenigstens einer der Flächen des ersten oder des zweiten Substrats, die dazu vorgesehen sind, durch molekulares Kleben verklebt zu werden, umfasst, das so ausgeführt wird, dass die erhaltene Rauheit im Bereich von 0,1 nm bis 1 nm RMS liegt, was ermöglicht, die Klebeenergie trotz des Festwerdens, das normalerweise aufgrund der Wärmebehandlung im Schritt c) auftritt, zu verringern, und
• das Trennen innerhalb einer zerbrechlichen Zone ausgeführt wird, die durch die Grenzfläche des molekularen Klebens zwischen dem ersten und dem zweiten Substrat gebildet wird.

2. Verfahren nach Anspruch 1, **dadurch gekennzeichnet, dass** das konstitutive Material dieser Referenzschicht mit jenem der amorphen Zonen übereinstimmt.

3. Verfahren nach Anspruch 1, **dadurch gekennzeichnet, dass** das konstitutive Material der Referenzschicht und dasjenige der amorphen Zonen ein gemeinsames Element enthalten.

4. Verfahren nach einem der Ansprüche 1 bis 3, **dadurch gekennzeichnet, dass** die Mischschicht aus einem einzigen Material verwirklicht ist, das je nach Zone im Voraus definierte kristallographische Orientierungen hat.

5. Verfahren nach Anspruch 4, **dadurch gekennzeichnet, dass** die zweiten Zonen durch Amorphisierung einer monokristallinen Schicht, die zunächst die kristallographische Orientierung der ersten Zonen hat, erhalten werden.

6. Verfahren nach einem der Ansprüche 1 bis 3, **dadurch gekennzeichnet, dass** die zweiten Zonen durch Vertiefung einer monokristallinen Schicht, die zunächst die kristallographische Orientierung der ersten Zonen hat, und durch Abscheidung des zweiten Materials in amorpher Form in den somit vertieften Hohlräumen gebildet werden.

7. Verfahren nach Anspruch 6, **dadurch gekennzeichnet, dass** die Abscheidung des amorphen Materials ausgeführt wird, bis eine die ersten Zonen abdeckende Schicht gebildet ist.

8. Verfahren nach einem der Ansprüche 1 bis 7, **dadurch gekennzeichnet, dass** die ersten und zweiten Zonen aus Silicium sind und die elektrisch isolierende ununterbrochene Schicht aus Siliciumoxid ist.

9. Verfahren nach einem der Ansprüche 1 bis 8, **dadurch gekennzeichnet, dass** die thermische Rekristallisationsverarbeitung dafür ausgelegt ist, die Rekristallisation nur in einem Teil der amorphen Zonen hervorzurufen, wobei nach dem Trennen eine zweite thermische Verarbeitung angewendet wird, die dafür ausgelegt ist, die Rekristallisation dieser amorphen Zonen zu vervollständigen.

10. Verfahren nach einem der vorhergehenden Ansprüche, wobei das Trennen durch mechanisches Einfügen eines Werkzeugs oder eines Fluids oder durch Schallwellen in die zerbrechliche Zone erfolgt.

## Claims

1. Process for producing a hybrid substrate, in which:
a) a first substrate (10, 110, 210) is prepared comprising a mixed layer that lies alongside a continuous, electrically insulating underlying layer and that is formed from single-crystal first zones (12A, 112A, 212A) made of at least one crystalline first material, and adjacent second zones made of an amorphous second material (12B, 112B, 212B), the second zones forming at least one portion of the free surface of this first substrate;
b) a second substrate (20, 120, 220), comprising on its surface a reference layer having a given crystal orientation, is bonded to this first substrate by molecular bonding in at least the amorphous zones;
c) a heat treatment is carried out on the mixed layer, said heat treatment being suitable for causing at least one portion of the amorphous zones (12B, 112B, 212B) to recrystallize, in the solid state, with the crystal orientation of the reference layer (20, 120, 220), this reference layer acting as a crystallization seed across the bonding interface; and
d) the reference layer of the second substrate and the at least partially recrystallized zones of the first substrate are separated,
**characterized in that**
• the molecular bonding is hydrophobic;
• before step b), the process comprises roughening at least one of the faces, of the first or second substrate, intended to be bonded by molecular bonding, carried out so that the roughness obtained is comprised between 0.1 nm and 1 nm RMS, thereby allowing the bonding energy to be decreased despite the consolidation that normally takes place because of the heat treatment in step c); and
• the separation takes place in a fragile zone consisting of the molecular bonding interface between the first and second substrates.

2. Process according to Claim 1, **characterized in that** the constituent material of the reference layer is identical to that of the amorphous zones.

3. Process according to Claim 1, **characterized in that** the constituent material of the reference layer and that of the amorphous zones comprise a common element.

4. Process according to any one of Claims 1 to 3, **characterized in that** the mixed layer is made of a single material having, depending on the zone, a preset crystal orientation.

5. Process according to Claim 4, **characterized in that** the second zones are obtained by amorphisation of a single-crystal layer initially having the crystal orientation of the first zones.

6. Process according to any one of Claims 1 to 3, **characterized in that** the second zones are formed by digging a single-crystal layer initially having the crystal orientation of the first zones and by depositing the amorphous second material in the cavities thus dug.

7. Process according to Claim 6, **characterized in that** the amorphous material is deposited until a layer covering the first zones has been formed.

8. Process according to any one of Claims 1 to 7, **characterized in that** the first and second zones are made of silicon and the continuous electrically insulating layer is made of silicon oxide.

9. Process according to any one of Claims 1 to 8, **characterized in that** the recrystallizing heat treatment is suitable for causing the recrystallization of only one portion of the amorphous zones and, after separation, a second heat treatment is applied suitable for completing the recrystallization of these amorphous zones.

10. Process according to any one of the preceding claims, in which the separation is achieved by mechanical insertion of a tool or a fluid or by acoustic waves in the fragile zone.
